# FASCICULE DE BREVET EUROPEEN

(11) **EP 1 562 207 B1**
(45) Date de publication et mention de la délivrance du brevet: **03.01.2007**
(21) Numéro de dépôt: 05290164.2
(22) Date de dépôt: 25.01.2005
(51) Int. Cl.: H01H 1/00, H01H 59/00, H01H 50/00, H01H 5/18, B81B 3/00

(54) **Microsystème électromécanique pouvant basculer entre deux positions stables**
Mikroelektromechanisches System mit zwei stabilen Kipplagen
Bistable microelectromechanical system

(30) Priorité: 04.02.2004 FR 0401074
(43) Date de publication de la demande: 10.08.2005
(73) Titulaire: STMicroelectronics SA, 92120 Montrouge (FR)
(72) Inventeur: Bouche, Guillaume, 38000 Grenoble (FR)
(74) Mandataire: Verdure, Stéphane

(56) Documents cités:
- EP-A- 1 220 256
- DE-A- 10 040 867
- US-B1- 6 351 201
- US-B1- 6 473 361
- PATENT ABSTRACTS OF JAPAN vol. 2003, no. 07, 3 juillet 2003 (2003-07-03) -& JP 2003 062798 A (ADVANTEST CORP), 5 mars 2003 (2003-03-05)

## Description

La présente invention concerne un dispositif électromécanique à élément déformable. Ce type de dispositifs peut constituer un micro-commutateur particulièrement adapté à la commutation d'éléments d'un circuit électronique, électrique ou optique.

Ces micro-commutateurs sont des microsystèmes électromécaniques ou MEMS (de l'anglais « Micro-Electro Mechanical Systems ») présentant deux états différents pour ouvrir ou fermer un circuit et ainsi activer ou désactiver le fonctionnement d'un dispositif électronique, optique, ou autre. Les MEMS sont couramment utilisés dans des applications telles que les télécommunications, les communications radio fréquences, l'électronique portable, l'électronique grand public, industrielle ou aérospatiale, ainsi que dans d'autres domaines.

Les MEMS à éléments déformables comprennent généralement un élément déformable en forme de poutre, qui est rattaché par une seule extrémité ou bien par des extrémités opposées sur un substrat et qui permet d'obtenir un basculement entre une première position stable et une seconde position stable par effet bilame thermique, actionnement électromagnétique ou/et électrostatique.

Les figures 1(a) à 1(c) présentent une réalisation connue d'un microsystème conforme au document EP 1220256.

Ce microsystème est réalisé sur un substrat 1. Le substrat 1 supporte des éléments conducteurs disjoints 50 simplement séparés par un faible intervalle à la verticale d'un élément déformable ayant la forme d'une poutre 10. La poutre 10 peut se déformer dans une cavité 2 aménagée dans le substrat 1. Elle est pourvue, du côté de la cavité 2, d'un élément de contact 40 apte à assurer une continuité électrique entre les éléments conducteurs disjoints 50 lorsque la poutre 10 fléchit dans la cavité 2. La poutre 10 supporte deux éléments résistifs 21 et 22 situés vers les extrémités de la poutre, et présentant un coefficient de dilatation thermique différent de celui de la poutre 10. Les éléments 21 et 22 forment des moyens de commande de basculement de la poutre. Des électrodes de maintien électrostatique sont également disposées par paires et en vis-à-vis : la paire d'électrodes 15 et 55 d'une part et la paire d'électrodes 16 et 56 d'autre part. Les électrodes 15 et 16 sont supportées par la poutre 10. Elles peuvent aussi être incluses dans la poutre. Les électrodes 55 et 56 sont disposées au fond de la cavité 2, sur le substrat 1.

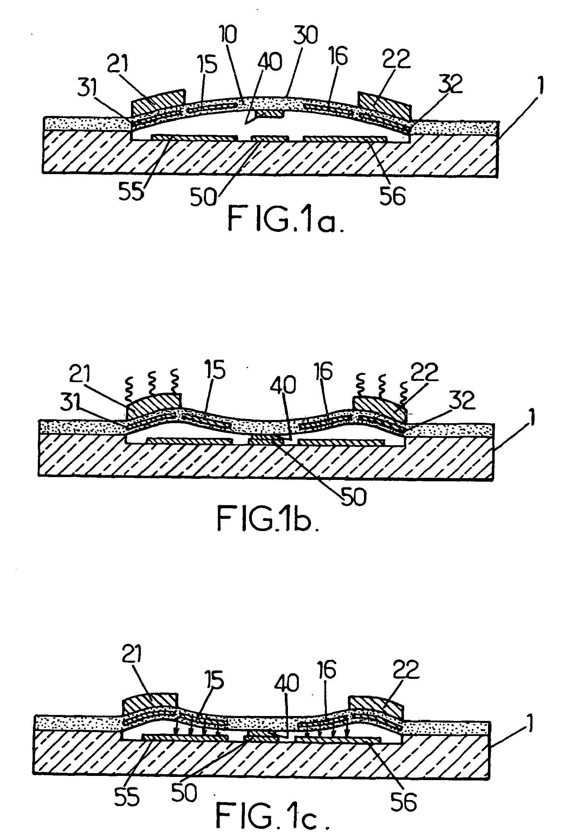

La figure 1(a) montre le microsystème électromécanique dans l'état désactivé, car l'élément de contact 40 n'assure pas la continuité électrique entre les éléments conducteurs disjoints 50.

Lorsqu'un courant électrique de commande circule directement dans les éléments résistifs 21 et 22 ou dans des électrodes 31 et 32 incluses dans la poutre 10 sous les éléments 21 et 22 respectivement, l'apport de chaleur qui en résulte provoque, par effet bilame, le fléchissement de la poutre vers le fond de la cavité 2. L'élément de contact 40 vient s'appuyer sur les éléments conducteurs disjoints 50 et assure la continuité électrique. C'est ce que montre la figure 1(b). Le microsystème électromécanique est alors dans l'état activé.

Les électrodes 15 et 55 d'une part et 16 et 56 d'autre part présentent alors un écartement minimal et assurent par l'application de tensions appropriées le maintien électrostatique de la poutre fléchie lorsque le courant électrique a cessé de passer dans les éléments résistifs 21 et 22, ou les électrodes 31 et 32, comme le montre la figure 1 (c). L'annulation des tensions de maintien électrostatique permet à la poutre de revenir à sa position de repos. Le microsystème électromécanique retourne alors dans l'état désactivé.

Cette réalisation comporte cependant des inconvénients lorsqu'il s'agit d'assurer la fiabilité du contact face à l'usure liée à des nombres de cycles très élevés (supérieur à 10⁹) comme dans certains types d'application. La détérioration du contact peut entraîner des transmissions capacitives entre les éléments conducteurs disjoints en position désactivée. L'utilisation de bossages sur les contacts n'est pas une solution satisfaisante à cause des difficultés liées à leur positionnement.

Un autre problème lié à cette réalisation est la tension électrique nécessaire au maintien dans la position fermée. En effet, une consommation électrique la plus faible possible constitue une contrainte commune à tous les types de microsystèmes électromécaniques, soit pour une question d'autonomie dans le cas d'un système portable, soit pour limiter les échauffements thermiques dans tous les cas.

Enfin les incertitudes de fabrication, face aux dimensions typiques de l'élément déformable (le rapport entre la distance de fléchissement de l'élément déformable et sa longueur peut être de 1 à 200), contribue à diminuer la fiabilité du contact.

Une solution à ces problèmes a été trouvée en prévoyant les éléments conducteurs associés aux éléments de contact sur l'élément déformable.

L'invention concerne ainsi un microsystème électromécanique comprenant :
- des éléments conducteurs disjoints,
- un premier élément déformable électromécaniquement pouvant basculer entre une première et une deuxième positions stables,
- des éléments de contact permettant la continuité électrique entre lesdits éléments conducteurs disjoints,
- des éléments de commande de basculement assurant le basculement du premier élément déformable, de manière à établir la continuité électrique entre les éléments conducteurs disjoints dans la deuxième position stable par contact entre les éléments de contacts et à rompre cette continuité électrique par espacement des éléments de contact dans la première position stable,
dans lequel les éléments conducteurs disjoints ainsi que les éléments de contacts sont portés par le premier élément déformable.

Ainsi la fiabilité du contact ne repose pas sur deux éléments dissociés, et donc susceptibles de présenter un écartement mal contrôlé et variable dans le temps.

Les éléments de commande de basculement du microsystème électromécanique peuvent avantageusement comprendre un second élément déformable électromécaniquement, distinct mais solidaire du premier élément déformable. Les éléments de commande sont ainsi distribués sur les deux éléments déformables. Chacun d'eux assure le basculement de l'une déterminée des positions stables dans l'autre.

De préférence, les positions stables peuvent correspondre à des positions de flambage respectives de l'un au moins des deux éléments déformables. Le maintien du contact électrique est ainsi assuré grâce à l'énergie interne stockée dans l'un au moins des éléments déformables, sans recours à une force de maintien extérieure. Par ailleurs, le risque de désalignement des éléments de contact est fortement réduit car une évolution de la géométrie des poutres liée à une variation des contraintes dans le temps entraîne un même déplacement des éléments de contact.

D'autres caractéristiques et avantages de l'invention apparaîtront encore à la lecture de la description qui va suivre. Celle-ci est purement illustrative et doit être lue en regard des dessins annexés sur lesquels :
- la figure 1(a) est un schéma en coupe verticale d'un microsystème électromécanique dans une première position stable,
- la figure 1 (b) est un schéma en coupe verticale d'un microsystème électromécanique déformé par effet bilame sous l'action des éléments résistifs,
- la figure 1(c) est un schéma en coupe verticale d'un microsystème électromécanique dans une deuxième position stable, maintenu grâce aux éléments de maintien électrostatique,
- la figure 2(a) est un schéma de principe du microsystème électromécanique selon l'invention dans une première position stable,
- la figure 2(b) est un schéma de principe du microsystème électromécanique selon l'invention dans une deuxième position stable,
- la figure 3 est une vue schématique et en perspective d'un mode de réalisation d'un microsystème électromécanique selon l'invention,
- la figure 4(a) est une vue schématique en coupe A-A d'une première étape de réalisation d'un microsystème électromécanique selon l'invention,
- la figure 4(b) est une vue schématique en coupe A-A d'une deuxième étape de réalisation d'un microsystème électromécanique selon l'invention,
- la figure 4(c) est une vue schématique en coupe A-A d'une troisième étape de réalisation d'un microsystème électromécanique selon l'invention,
- la figure 4(d) est une vue schématique en coupe A-A d'une quatrième étape de réalisation d'un microsystème électromécanique selon l'invention,
- la figure 4(e) est une vue schématique en coupe A-A d'une cinquième étape de réalisation d'un microsystème électromécanique selon l'invention,
- la figure 4(f) est une vue schématique en coupe A-A d'une sixième étape de réalisation d'un microsystème électromécanique selon l'invention,
- la figure 4(g) est une vue schématique vue de dessus d'une septième étape de réalisation d'un microsystème électromécanique selon l'invention,
- la figure 5(a) est une vue schématique en coupe A-A d'un mode de réalisation d'un microsystème électromécanique selon l'invention, lorsque le microsystème électromécanique est désactivé,
- la figure 5(b) est une vue schématique en coupe B-B d'un mode de réalisation d'un microsystème électromécanique selon l'invention, lorsque le microsystème électromécanique est activé,

Les figures 1(a) à 1(c), qui correspondent à l'état de la technique, ont déjà fait l'objet d'une description ci-dessus en introduction.

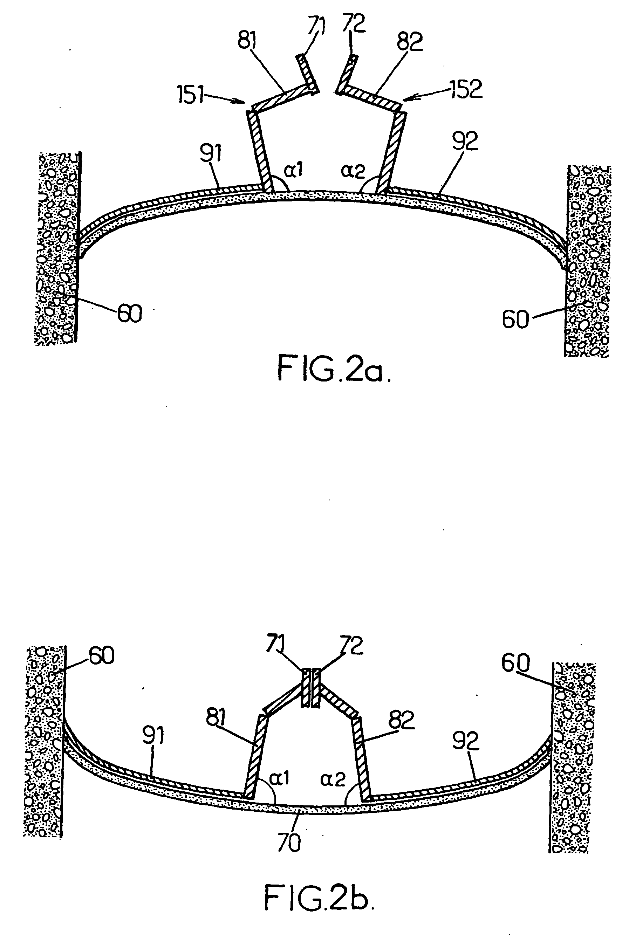

Le principe de réalisation du microsystème électromécanique selon l'invention est présenté aux figures 2(a) et (2(b). Un élément mobile en forme de poutre 70 est maintenu en compression entre deux éléments fixes 60. La poutre subit donc une déformation latérale de part la charge en bout qui impose un travail en compression, ou flambage. La poutre 70 peut donc occuper deux positions stables correspondant à un minimum d'énergie interne. Une première position stable, appelée également position ouverte, est représentée à la figure 2(a) et une deuxième position stable, appelée également position fermée, est représentée à la figure 2(b).

Sur la figure 2(a), des éléments conducteurs disjoints 91 et 92 sont solidaires de la poutre 70. Deux bras sensiblement rigides 81 et 82, présentant des extrémités 71 et 72, sont liés respectivement aux éléments conducteurs disjoints 91 et 92, et forment des angles α1 et α2 non nuls. Ici, ils sont choisis substantiellement droits. Les bras 81 et 82, associés aux extrémités respectives 71 et 72 forment les éléments de contact 151 et 152 respectivement. Dans la position ouverte, les bras sont agencés de manière à ce que leurs extrémités respectives 71 et 72 ne soient pas en contact : il n'y a donc pas de continuité électrique entre les éléments conducteurs 91 et 92 et le microsystème électromécanique est dans l'état désactivé.

Lorsque la poutre 70 bascule dans la deuxième position stable ou position fermée par des éléments de commande de basculement (non représentés), elle entraîne les éléments conducteurs 91 et 92, ainsi que les bras 81 et 82, de manière à amener les extrémités 71 et 72 en contact. On obtient alors la configuration représentée à la figure 2 (b). Il y a alors continuité électrique entre les éléments conducteurs 91 et 92 et le microsystème électromécanique est dans l'état activé. Les deux éléments conducteurs disjoints 91 et 92 sont donc maintenus en contact via les deux bras 81 et 82 et leur extrémité 71 et 72 grâce uniquement à l'énergie interne de la poutre 70 liée au flambage. Il n'y a donc pas de recours à une force extérieure pour maintenir le contact entre les éléments disjoints via les éléments de contact 151 et 152, hormis l'énergie ponctuellement nécessaire au basculement.

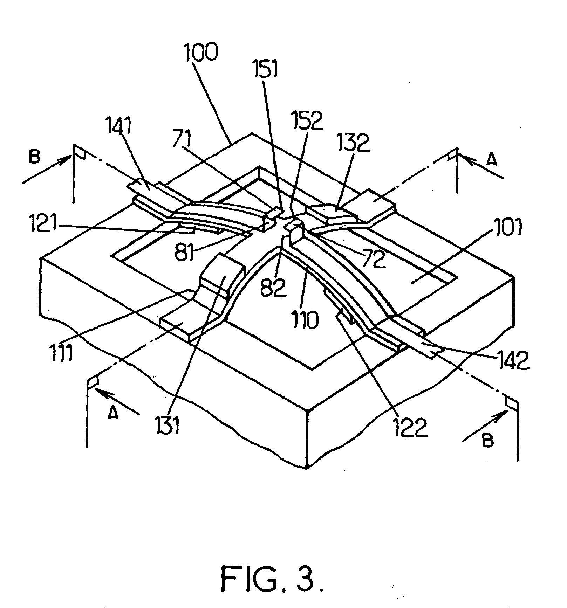

Un exemple de réalisation d'un microsystème électromécanique selon l'invention est représenté schématiquement à la figure 3. Un microsystème électromécanique est réalisé sur un substrat 100 formé d'une ou plusieurs couches identiques ou non, par exemple en silicium, en silice, en verre ou en quartz. Deux éléments déformables solidaires 110 et 111, ayant la forme par exemple de poutres ou de membrane, et formant un motif en croix, sont déposés sur le substrat 100. Elles sont constituées d'un matériau mauvais conducteur thermique, par exemple en Nitrure de Silicium (SᵢN), en Oxyde de Silicium (SᵢO₂), en Polysilicium (Poly-Sᵢ), en Nitrure de Titane (TᵢN) ou en Nitrure de Tantale (TaN). Les deux poutres occupent une première position stable de flambage, grâce au mode de réalisation des éléments déformables qui sera exposé plus loin. Une cavité 101 est aménagée dans le substrat 100 afin de permettre le basculement des poutres 110 et 111 vers la deuxième position stable de flambage. La poutre 110 est pourvue de deux éléments conducteurs disjoints 141 et 142, munis respectivement d'éléments de contact 151 et 152. Les éléments de contacts 151 et 152 comprennent les bras 81 et 82, associés respectivement aux extrémités 71 et 72. Les bras 81 et 82 sont sensiblement rigides et forment des angles non nuls α1 et α2 avec la poutre 110. La première position stable représentée à la figure 3 correspond à la position ouverte car les extrémités 71 et 72 des bras 151 et 152 n'assurent pas la continuité électrique entre les éléments conducteurs 141 et 142.

Plusieurs types d'éléments de commande de basculement sont envisageables afin d'activer ou de désactiver le microsystème électromécanique. Ils comprennent des premiers éléments de commande de basculement depuis la seconde position stable (position fermée) vers la première position stable (position ouverte) ainsi que des seconds éléments de commande de basculement pour le basculement inverse, depuis la première position stable vers la seconde position stable. Un exemple d'éléments de commande de basculement thermique est représenté à la figure 3. La poutre 110 supporte deux éléments résistifs 121 et 122 situés vers les extrémités de la poutre et en contact intime avec celle-ci. Ces éléments résistifs doivent présenter un coefficient de dilatation thermique différent de celui des poutres et peuvent être des dépôts d'un matériau conducteur par exemple de l'aluminium, du manganèse, du zinc, de l'or, du platine, du nickel ou de l'inconel 600 ®. La poutre 111 supporte également deux éléments résistifs 131 et 132 situés vers les extrémités de la poutre et en contact intime avec cette dernière, mais sur une face opposée à celle sur laquelle sont situés les éléments résistifs 121 et 122. On peut envisager également de venir déposer dans les éléments déformables, à la verticale des quatre éléments résistifs 121, 122, 131, et 132, des électrodes chauffantes (non représentées) en Nitrure de Titane par exemple qui commandent l'apport de chaleur reçu par les éléments résistifs. Les électrodes chauffantes ou les éléments résistifs sont reliés directement à des sources de courant par des lignes de connexion (non représentées).

Partant de la position ouverte, lorsque un courant électrique de commande circule dans les éléments résistifs 131 et 132 ou dans les électrodes chauffantes situées à la verticale de 131 ou 132, l'apport de chaleur qui en résulte provoque, par effet bilame, le fléchissement des poutres 111 et 110 vers le fond de la cavité 101 dans la deuxième position stable. De fait, le fléchissement de la poutre 111 entraîne celui de la poutre 110, les deux poutres 110 et 111 étant solidaires. Les extrémités 71 et 72 des bras 151 et 152 sont amenées en contact et assurent la continuité électrique entre les éléments conducteurs 141 et 142. Le microsystème électromécanique est dans l'état activé.

Inversement, lorsque un courant électrique de commande circule dans les éléments résistifs 121 et 122, ou dans les électrodes chauffantes situées à la verticale de 121 et 122, l'apport de chaleur qui en résulte provoque, par effet bilame, le fléchissement des poutres 110 et 111 vers la première position stable. La continuité électrique entre les éléments conducteurs 141 et 142 est rompue par espacement des éléments de contact 151 et 152. Le microsystème électromécanique est désactivé.

D'autres modes de réalisation des éléments de commande de basculement sont envisageables.

On peut envisager des éléments de commandes comprenant un actionnement électrostatique comme divulgué dans le document EP 1220256 cité plus haut. Ils comprennent au moins une paire d'électrode en vis-à-vis, l'une des électrodes est solidaire d'un des éléments déformables, l'autre est positionnée au fond de la cavité 101, en vis-à-vis de la premier électrode. L'écart entre les électrodes est maximal lorsque le microsystème électromécanique est désactivé dans la première position stable. Ces électrodes sont utilisées non pas pour le maintien en position activée du microsystème électromécanique comme dans le document EP 1220256, mais pour assurer le basculement vers la deuxième position stable en appliquant des tensions électrostatiques sur les électrodes. L'écart entre les deux électrodes est alors minimal. Le basculement vers la première position stable peut être assuré par des moyens de basculement thermique ou autres comme présenté ci-après.

Des éléments de commande électromagnétiques, avec un champ magnétique polarisable pour assurer le basculement d'une position stable à une autre sont connus par le brevet US 6496612 B1. Ils comprennent au moins un élément magnétiquement sensible solidaire de l'un des éléments déformables, ainsi que des éléments générant un champ magnétique variable, et adaptés pour provoquer le basculement dans l'une des positions stables.

On peut aussi substituer aux éléments résistifs des éléments de déformation piézo-électrique, positionnés de part et d'autre de l'une des poutres ou sur des faces opposées de chacun des deux poutres. Partant de la position ouverte, l'application d'une première tension aux éléments supérieurs permet le basculement vers la position fermée alors que l'application d'une deuxième tension aux éléments supérieurs permet le basculement inverse.

Il est également possible de faire appel à des premiers et seconds éléments de commande de basculement distincts pour assurer respectivement le basculement vers la première position stable d'une part et le basculement vers la seconde position stable d'autre part, en combinant l'un des types précédents de commande de basculement.

Il est également possible d'envisager le cas d'un microsystème électromécanique ne présentant qu'un seul élément déformable. Les premiers et seconds moyens de basculement sont alors portés par cet élément déformable unique.

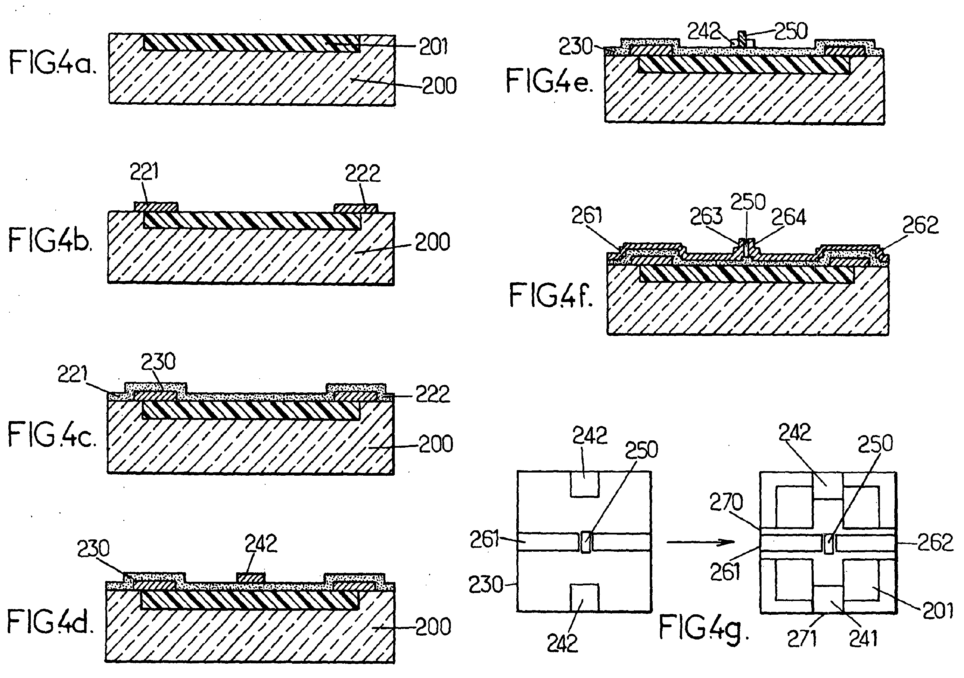

Les figures 4(a) à 4(f) présentent des vues en coupe d'un exemple de procédé de fabrication possible d'un microsystème électromécanique selon l'invention, avec quatre éléments résistifs comme éléments de commande de basculement, à raison de deux par élément déformable, et des électrodes chauffantes à leur verticale. Les premiers et les seconds éléments de commande de basculement sont donc identiques. Le plan de coupe est le plan A-A de la figure 3. La figure 4(g) montre une vue de dessus de l'ultime étape de l'exemple de procédé de fabrication.

La figure 4(a) représente la première étape avec la gravure d'un substrat 200, en Silicium par exemple, et le dépôt d'un polymère sacrificiel 201 dans une cavité réservée à cet effet. Ce polymère peut être une résine résistante au dépôt ultérieur de nitrure par exemple, et est destinée à être enlevée par la suite. Une planarisation (chemical mechanical polishing en anglais) de la couche sacrificielle est ensuite réalisée.

Lors de la deuxième étape représentée à la figure 4(b), deux éléments résistifs ou plots, en l'occurrence 221 et 222, sur les quatre servant à l'effet bilame, sont déposés. Ils peuvent être notamment en aluminium. Ils correspondent aux plots situés sous le premier élément déformable.

Lors d'une troisième étape représentée à la figure 4(c), une membrane très compressive 230, en Nitrure de Silicium Si₃N₄ par exemple, est déposée en deux couches. Entre ces deux couches, sont déposées des résistantes chauffantes, non représentées, en Nitrure de Titane TiN, chacune à la verticale des plots correspondants aux éléments résistifs. Les amenées de courant à ces électrodes chauffantes sont aussi réalisées à cette étape. Un tel dépôt de membranes compressives de Nitrure de Silicium peut être effectué selon les principes exposés dans l'article de K.Osada et al. : « Effect of stress in the deposited Silicon nitride films on Boron diffusion of silicon », publié dans J.Electrochem. Soc., vol 142, n°1, jan 1995.

Les deux derniers plots servant à l'effet bilame sont déposés à la quatrième étape représentée à la figure 4(d). Seul le plot 242 est représenté sur cette figure selon la coupe A-A.

Une deuxième couche sacrificielle 250 est déposée puis gravée partiellement lors de la cinquième étape représentée à la figure 4(e) afin de préparer le dépôt des éléments conducteurs disjoints.

Un dépôt métallique pleine plaque est réalisé lors de la sixième étape représentée à la figure 4(f) suivi d'une gravure sélective du métal afin d'obtenir les deux éléments conducteurs disjoints 261 et 262. Le métal situé sur la couche 250 entre les extrémités 263 et 264 est retiré afin d'assurer la discontinuité électrique.

Une vue de dessus du résultat de la sixième étape apparaît sur la figure 4(g), on retrouve les deux plots 241 et 242 situés sur la couche de Nitrure de Silicium qui recouvre l'ensemble de la cavité. Une nouvelle gravure sélective, cette fois du nitrure, permet de faire apparaître les deux éléments solidaires et déformables 270 et 271.

Le retrait des couches sacrificielles permet alors de libérer les éléments déformables, qui du fait de l'énergie interne stockée résultant de dépôt en compression de la couche de Nitrure de Silicium, basculent dans l'une ou l'autre des positions stables.

En fonction de la position de flambage, i.e. si la continuité électrique est assurée ou non, une étape de réinitialisation du microsystème électromécanique peut s'avérer nécessaire à partir des éléments de commande de basculement.

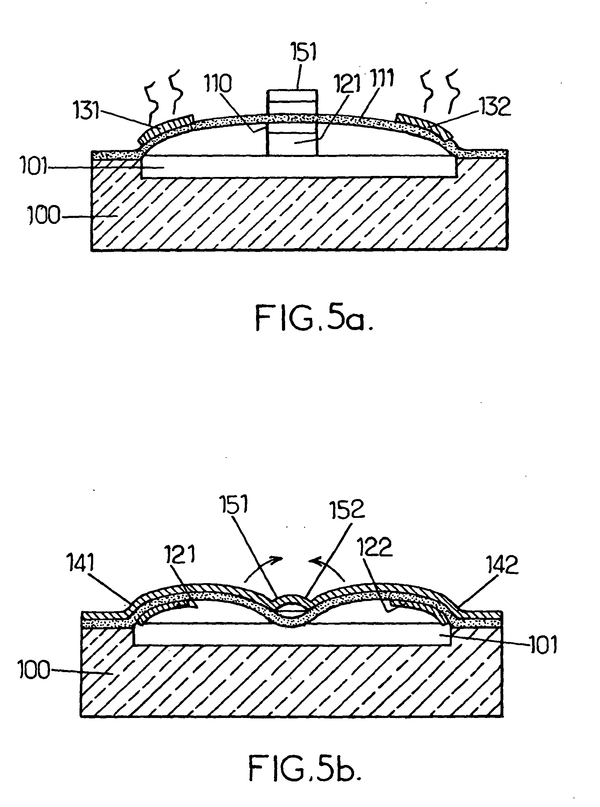

Les figures 5(a) et 5(b) représentent des vues en coupe de la figure 3. Les numéros identiques correspondent aux mêmes éléments que sur la figure 3.

La figure 5(a) représente une vue selon la coupe A-A de la figure 3. Le microsystème électromécanique est dans l'état désactivé car les éléments déformables 110 et 111 sont dans la première position stable. Les éléments résistifs 131 et 132 se situent en partie supérieure de l'élément déformable 111. Lorsque un courant électrique de commande circule dans les éléments résistifs 131 et 132 ou dans les électrodes chauffantes à la verticale des éléments résistifs 131 et 132 (non représentées), l'effet bilame résultant de la dilatation différentielle entre les éléments résistifs et l'élément déformable 111 va entraîner ce dernier ainsi que l'élément déformable 110 solidaire vers la seconde position stable, représentée à la figure 5(b).

La figure 5(b) représente une vue selon la coupe B-B de la figure 3. Les éléments déformables 110 et 111 sont dans la seconde position stable. Les bras 151 et 152 sont alors en contact grâce uniquement à l'énergie interne des éléments déformables 110 et 111, liée au flambage. La continuité électrique entre les éléments conducteurs disjoints 141 et 142 est assurée. Le microsystème électromécanique est alors dans l'état activé.

On peut noter que, en cas d'évolution dans le temps des contraintes et donc de la géométrie des poutres, les contacts en regard subissent un même déplacement et donc que le risque de désalignement est fortement réduit grâce à l'invention.

## Revendications

1. Microsystème électromécanique comprenant :
- des premiers et seconds éléments conducteurs disjoints (141, 142),
- un premier élément déformable électromécaniquement (110) pouvant basculer entre une première et une seconde positions stables,
- des éléments de contact (151, 152) permettant la continuité électrique entre lesdits éléments conducteurs disjoints,
- des éléments de commande de basculement (111, 131, 132, 121, 122) assurant le basculement dudit premier élément déformable, de manière à établir ladite continuité électrique entre lesdits éléments conducteurs disjoints dans ladite seconde position stable par contact entre lesdits éléments de contact et à rompre ladite continuité électrique par espacement desdits éléments de contact dans ladite première position stable,
dans lequel les premiers et seconds éléments conducteurs disjoints ainsi que les éléments de contact sont portés par le premier élément déformable.

2. Microsystème électromécanique selon la revendication 1, dans lequel les éléments de commande de basculement comprennent en outre un second élément déformable électromécaniquement (111) distinct mais solidaire du premier élément déformable.

3. Microsystème électromécanique selon la revendication 1 ou 2, dans lequel les premières et secondes positions stables correspondent à des positions de flambage du premier et/ou du second élément déformable.

4. Microsystème électromécanique selon la revendication 3, dans lequel les éléments de commande de basculement comprennent des premiers éléments de commande de basculement depuis la seconde position stable vers la première position stable et des seconds éléments de commande de basculement depuis la première position stable vers la seconde position stable.

5. Microsystème électromécanique selon la revendication 4, dans lequel les premiers et/ou les seconds éléments de commande de basculement comprennent au moins un élément résistif (121, 122, 131, 132) en contact intime avec l'un des premier et second éléments déformables, ledit élément résistif assurant le basculement entre les deux positions stables par effet bilame lorsqu'il est traversé par un courant électrique de commande ou qu'il reçoit un apport de chaleur.

6. Microsystème électromécanique selon la revendication 4, dans lequel les seconds éléments de commande de basculement comprennent des éléments de déformation électrostatiques, incluant au moins une paire d'électrodes en vis-à-vis, dont l'une est solidaire d'un des premier et second éléments déformables, et dont l'autre est située de façon que, lorsque le premier élément déformable a basculé dans la seconde position stable, l'écart entre les électrodes en vis-à-vis est minimal dans l'une des positions stables et maximal dans l'autre.

7. Microsystème électromécanique selon la revendication 4, dans lequel les premiers et/ou les seconds éléments de commande de basculement comprennent au moins un élément magnétiquement sensible solidaire de l'un des premier et second éléments déformables et des éléments générant un champ magnétique variable adaptés pour provoquer le basculement dans l'une des positions stables.

8. Microsystème électromécanique selon la revendication 4, dans lequel les premiers et/ou les seconds éléments de commande de basculement comprennent des éléments de déformation piézo-électrique, comprenant au moins un élément piézo-électrique solidaire de l'un des premier et second éléments déformables de manière qu'une tension électrique appliquée audit élément piézo-électrique provoque le basculement dans l'une des première et seconde positions stables.

9. Microsystème électromécanique selon l'une des revendications 1 à 8, dans lequel les premiers et seconds éléments de commande de basculement sont identiques.

10. Microsystème électromécanique selon l'une des revendications 1 à 8, dans lequel les premiers et seconds éléments de commande de basculement sont distincts.

11. Microsystème électromécanique selon l'une des revendications précédentes, dans lequel les éléments de contact comprennent au moins deux bras disjoints et électriquement conducteurs (81, 82) liés respectivement aux éléments conducteurs disjoints, et sont agencés sur lesdits premiers et seconds éléments conducteurs disjoints de manière à former un angle non nul (α1, α2) avec le premier élément déformable, et à être en contact l'un avec l'autre afin d'établir la continuité électrique entre lesdits éléments conducteurs disjoints lorsque les éléments déformables sont dans la première position stable et être séparés l'un de l'autre lorsque les éléments déformables sont dans la deuxième position stable.

## Claims

1. Microelectromechanical system comprising:
- first and second separate conducting elements (141, 142);
- a first electromechanically deformable element (110) that can switch between a first stable position and a second stable position;
- contact elements (151, 152) allowing electrical continuity between the said separate conducting elements;
- switch control elements (111, 131, 132, 121, 122) ensuring that the said first deformable element switches so as to establish the said electrical continuity between the said separate conducting elements in the said second stable position by contact between the said contact elements and to break the said electrical continuity by separating the said contact elements in the said first stable position,
in which the first and second separate conducting elements and the contact elements are carried by the first deformable element.

2. Microelectromechanical system according to Claim 1, in which the switch control elements furthermore comprise a second electromechanically deformable element (111) separate from but joined to the first deformable element.

3. Microelectromechanical system according to Claim 1 or 2, in which the first and second stable positions correspond to buckling positions of the first and/or second deformable element.

4. Microelectromechanical system according to Claim 3, in which the switch control elements comprise first switch control elements for switching from the second stable position to the first stable position and second switch control elements for switching from the first stable position to the second stable position.

5. Microelectromechanical system according to Claim 4, in which the first and/or second switch control elements comprise at least one resistive element (121, 122, 131, 132) in intimate contact with one of the first and second deformable elements, the said resistive element ensuring that switching takes place between the two stable positions by a bimetallic effect when an electrical control current flows through it or when it receives a supply of heat.

6. Microelectromechanical system according to Claim 4, in which the second switch control elements comprise electrostatic deformation elements, including at least one pair of facing electrodes, one of which is joined to one of the first and second deformable elements and the other of which is located so that, when the first deformable element has switched into the second stable position, the gap between the facing electrodes is a minimum in one of the stable positions and a maximum in the other.

7. Microelectromechanical system according to Claim 4, in which the first and/or second switch control elements comprise at least one magnetically sensitive element joined to one of the first and second deformable elements and elements generating a variable magnetic field which are suitable for causing switching into one of the stable positions.

8. Microelectromechanical system according to Claim 4, in which the first and/or second switch control elements comprise piezoelectric deformation elements, comprising at least one piezoelectric element joined to one of the first and second deformable elements so that an electrical voltage applied to the said piezoelectric element causes switching into one of the first and second stable positions.

9. Microelectromechanical system according to one of Claims 1 to 8, in which the first and second switch control elements are identical.

10. Microelectromechanical system according to one of Claims 1 to 8, in which the first and second switch control elements are different.

11. Microelectromechanical system according to one of the preceding claims, in which the contact elements comprise at least two separate and electrically conducting arms (81, 82) linked to the separate conducting elements respectively, and are placed on the said first and second separate conducting elements so as to make a non-zero angle (α1, α2) with the first deformable element, and so as to be in contact with each other so as to establish electrical continuity between the said separate conducting elements when the deformable elements are in the first stable position and to be separated from each other when the deformable elements are in the second stable position.

## Patentansprüche

1. Elektromechanisches Mikrosystem, umfassend:
- ein erstes und ein zweites Leiterelement (141, 142), die voneinander getrennt sind,
- ein erstes elektromechanisch verformbares Element (110), das zwischen einer ersten und einer zweiten stabilen Position kippen kann,
- Kontaktelemente (151, 152), die den elektrischen Stromfluss zwischen den voneinander getrennten Leiterelementen erlauben,
- Kippsteuerelemente (111, 131, 132, 121, 122), die das Kippen des ersten verformbaren Elements sicherstellen, um den genannten elektrischen Stromfluss zwischen den voneinander getrennten Leiterelementen in der genannten zweiten stabilen Position durch Kontakt zwischen den genannten Kontaktelementen herzustellen und den elektrischen Stromfluss durch einen Abstand der genannten Kontaktelemente in der genannten ersten stabilen Position abzubrechen,
bei dem das erste und zweite Leiterelement, die voneinander getrennt sind, sowie die Kontaktelemente durch das erste verformbare Element getragen sind.

2. Elektromechanisches Mikrosystem nach Anspruch 1, bei dem die Kippsteuerelemente außerdem ein zweites elektromechanisch verformbares Element (111) umfassen, das vom ersten verformbaren Element verschieden, aber mit diesem aus einem Stück ist.

3. Elektromechanisches Mikrosystem nach Anspruch 1 oder 2, bei dem die erste und zweite stabile Position Knickpositionen des ersten und/oder des zweiten verformbaren Elements entsprechen.

4. Elektromechanisches Mikrosystem nach Anspruch 3, bei dem die Kippsteuerelemente erste Steuerelemente zum Kippen aus der zweiten stabilen Position in die erste stabile Position und zweite Steuerelemente zum Kippen aus der ersten stabilen Position in die zweite stabile Position umfassen.

5. Elektromechanisches Mikrosystem nach Anspruch 4, bei dem das erste und/oder zweite Kippsteuerelement wenigstens ein Widerstandselement (121, 122, 131, 132) in engem Kontakt entweder mit dem ersten oder zweiten verformbaren Element umfasst, wobei das genannte Widerstandselement das Kippen zwischen den beiden stabilen Positionen durch Bimetalleffekt sicherstellt, wenn es von einem elektrischen Steuerstrom durchlaufen wird oder es eine Wärmezufuhr empfängt.

6. Elektromechanisches Mikrosystem nach Anspruch 4, bei dem die zweiten Kippsteuerelemente elektrostatische Verformungselemente umfassen, die wenigstens ein Paar von einander gegenüberliegenden Elektroden enthalten, von denen die eine entweder mit dem ersten oder zweiten verformbaren Element aus einem Stück ist und von denen die andere derart angeordnet ist, dass, wenn das erste verformbare Element in die zweite stabile Position gekippt ist, der Abstand zwischen den einander gegenüberliegenden Elektroden in der einen der stabilen Positionen minimal ist und in der anderen maximal.

7. Elektromechanisches Mikrosystem nach Anspruch 4, bei dem die ersten und/oder zweiten Kippsteuerelemente wenigstens ein magnetisch empfindliches Element, das entweder mit dem ersten oder zweiten verformbaren Elemente aus einem Stück ist, und ein variables magnetisches Feld erzeugende Elemente umfassen, die ausgelegt sind, um das Kippen in eine der stabilen Positionen zu bewirken.

8. Elektromechanisches Mikrosystem nach Anspruch 4, bei dem die ersten und/oder zweiten Kippsteuerelemente piezoelektrische Verformungselemente umfassen, die wenigstens ein piezoelektrisches Element enthalten, das aus einem Stück entweder mit dem ersten oder dem zweiten verformbaren Elemente besteht, derart, dass eine an das piezoelektrische Element angelegte elektrische Spannung das Kippen entweder in die erste oder zweite stabile Position bewirkt.

9. Elektromechanisches Mikrosystem nach einem der Ansprüche 1 bis 8, bei dem die ersten und zweiten Kippsteuerelemente gleich sind.

10. Elektromechanisches Mikrosystem nach einem der Ansprüche 1 bis 8, bei dem die ersten und zweiten Kippsteuerelemente unterschiedlich sind.

11. Elektromechanisches Mikrosystem nach einem der vorhergehenden Ansprüche, bei dem die Kontaktelemente wenigstens zwei getrennte und elektrisch leitende Arme (81, 82) umfassen, die mit dem einen bzw. dem anderen der voneinander getrennten Leiterelemente verbunden sind und an den voneinander getrennten ersten und zweiten Leiterelementen derart angebracht sind, dass sie einen von null abweichenden Winkel (α1, α2) mit dem ersten verformbaren Element bilden und miteinander in Kontakt sind, um den elektrischen Stromfluss zwischen den genannten getrennten Leiterelementen herzustellen, wenn die verformbaren Elemente in der ersten stabilen Position sind, und voneinander getrennt sind, wenn die verformbaren Elemente in der zweiten stabilen Position sind.
